# EUROPÄISCHE PATENTANMELDUNG

(11) **EP 1 895 825 A1**
(43) Veröffentlichungstag der Anmeldung: **05.03.2008**
(21) Anmeldenummer: 06018193.0
(22) Anmeldetag: 31.08.2006
(51) Int. Cl.: H05K 7/20

(54) **Aufbau für eine Stromversorgung mit einer Kühleinrichtung**

(71) Anmelder: Gesellschaft für Innovat. Industrieelektronik mbH, 83564 Soyen (DE)
(72) Erfinder: Kress, Ekkehard, 83512 Wasserburg (DE); Wieser, Hans-Peter, 83512 Wasserburg (DE)
(74) Vertreter: Oberhardt, Knut

(57) **Zusammenfassung**

Die Erfindung geht aus von einem Aufbau für eine Stromversorgung mit einer Kühleinrichtung, wobei die Kühleinrichtung einen Kreislauf für ein Kühlmittel mit einer Kühlmittelpumpe mit Pumpengehäuse und Pumpenrotor aufweist. Erfindungsgemäß ist ein Kühlkörper vorgesehen, in den Kühlmittelkanäle und das Pumpengehäuse integriert sind.

## Beschreibung

Die Erfindung betrifft einen Aufbau für eine Stromversorgung mit einer Kühleinrichtung nach dem Oberbegriff von Anspruch 1.

Für Anwendungen mit Leistungselektronik werden heute vermehrt Stromversorgungen mit einer Leistung von mehr als 3 kW benötigt. Bei Stromversorgungen in diesem Leistungsbereich ist eine Kühlung einzelner Komponenten unabdingbar. Eine entsprechende Kühleinrichtung besteht üblicherweise aus Leitungen für das Kühlmittel, einer Kühlmittelpumpe, einem Wärmetauscher zur Abkühlung des heißen Kühlmittels und aus Kühlblöcken, die den zu kühlenden Komponenten die Wärme entziehen und auf das Kühlmittel übertragen. Solche Kühleinrichtungen benötigen viel Raum und vergrößern damit das Volumen der zu kühlenden Stromversorgung. Weiterhin sind solche Kühleinrichtungen sehr aufwändig und wirken sich daher enorm auf die Gesamtherstellungskosten einer entsprechenden Stromversorgung aus.

Der Erfindung liegt die Aufgabe zugrunde, den Aufbau für eine Stromversorgung mit einer Kühleinrichtung so auszugestalten, dass eine kompakte Einheit entsteht und die Kühleinrichtung nur geringe zusätzliche Herstellkosten erfordert.

Gelöst wird die Aufgabe durch den Aufbau für eine Stromversorgung mit einer Kühleinrichtung mit den Merkmalen von Anspruch 1. Erfindungsgemäß ist ein Kühlkörper vorgesehen, in den Kühlmittelkanäle und das Pumpengehäuse integriert sind. Dieser Kühlkörper dient gleichzeitig als Grundplatte für die elektrischen Komponenten der Stromversorgung. Durch diese Maßnahmen wird eine hochgradige Integration der Kühleinrichtung in die Stromversorgung möglich. Auf ein eigenes Pumpengehäuse und auf den Großteil von Kühlmittelleitungen kann verzichtet werden, so dass sich auch die Herstellungskosten gegenüber herkömmlichen Aufbauten mit Kühleinrichtung senken lassen. Auf eine gesonderte Grundplatte kann gänzlich verzichtet werden.

Vorteilhafterweise wird als Pumpe eine Kreiselpumpe verwendet, deren Stator gegen Flüssigkeit isoliert ist. Das Spiralgehäuse ist als Vertiefung direkt in den Kühlkörper eingebracht. Der tangentiale Auslauf für das Kühlmittel geht in einen Kühlmittelkanal über, der ebenfalls direkt in den Kühlkörper eingebracht ist.

Von dem Pumpengehäuse führt eine zentrale Versorgungsbohrung für das Kühlmittel durch den Kühlkörper zu einem Kühlmittelvorratsbehälter, der direkt gegenüber dem Pumpengehäuse auf der anderen Seite des Kühlkörpers angebracht ist. Das Pumpengehäuse ist nahe einer der Seitenkanten des Kühlkörpers vorgesehen. Auf diese Weise wird es möglich, die Stromversorgung in unterschiedlichen Einbaulagen zu betreiben. Wenigstens in zwei Einbaulagen ist gewährleistet, dass die Kühlmittelpumpe immer mit Kühlmittel aus dem Vorratsbehälter versorgt wird und nicht trocken läuft. Besonders vorteilhaft ist der Kühlkörper quadratisch ausgebildet und weist eine Kantenlänge von 19" auf. Die so dimensionierte Stromversorgung kann daher in jeden handelsüblichen Elektronikschrank so eingebaut werden, dass einerseits die Kühlmittelpumpe immer mit Kühlmittel versorgt ist und sich die elektrischen Anschlüsse und die Anschlüsse für das Kühlmittel andererseits an einer den Umständen nach geeigneten Stelle befinden.

In einem Ausführungsbeispiel der Erfindung werden die Kühlmittelkanäle in dem Kühlkörper durch Tieflochbohrungen erzeugt. Diese Tieflochbohrungen werden von den Schmalseiten der Platte aus eingebracht, und dann über Verschlüsse wieder nach außen abgedichtet. Durch im Winkel aufeinander gesetzte Bohrungen entsteht so ein komplettes Kühlleitungssystem in dem Kühlkörper.

In einem bevorzugten Ausführungsbeispiel werden die Kühlmittelkanäle in dem Kühlkörper durch Fräsen erzeugt. Auf diese Weise kann in der Oberfläche des Kühlkörpers in einem Arbeitsgang das komplette Leitungssystem erzeugt werden. Die offenen Kanäle werden danach vollständig mit einer Deckplatte abgedeckt und so nach außen abgedichtet. Diese Deckplatte kann entweder verklebt oder mit einer Dichtung verschraubt werden. Bei diesem bevorzugten Ausführungsbeispiel ergibt sich in dem Kühlkanalsystem ein geringerer Strömungswiderstand, da die einzelnen geraden Teilstücke des Kanalsystems über Rundungen miteinander in Verbindung stehen und nicht wie bei dem oben beschriebenen Ausführungsbeispiel im Winkel aufeinander stehen.

Der Kühlkörper dient als Grundplatte für die elektrischen Komponenten der Stromversorgung. Diese Komponenten sind in drei Kategorien unterteilt: in einen Eingangskreis, einen Ausgangskreis und eine Steuerelektronik. Die Komponenten dieser drei Kategorien sind auf der Kühlplatte auch räumlich getrennt untergebracht. Dies ermöglicht eine genaue Anpassung der Kühlkanäle an die Erfordernisse. Da nur die Komponenten des Eingangs-und des Ausgangskreises eine große Menge Wärme produzieren, muss im Bereich der Steuerungselektronik keine Möglichkeit für die Abfuhr von Wärme geschaffen werden. Die Steuerungselektronik ist daher zwischen dem Eingangskreis und dem Ausgangskreis angeordnet: Um eine Störung der Steuerungselektronik durch die Komponenten des Eingangs- und Ausgangskreises zu vermeiden, ist die Steuerungselektronik in einer Abschirmbox untergebracht.

Um die Wärmeabfuhr zu optimieren, sind Komponenten des Eingangs- und Ausgangskreises auf Kühlblöcken angebracht, die über Bohrungen in dem Kühlkörper mit Kühlmittel versorgt werden. Auf diese Weise steht eine verhältnismäßig große gekühlte Fläche zur Verfügung. Ebenso kann durch diese Maßnahme aber die Stromversorgung auch noch kompakter gestaltet werden.

Um die Kühlblöcke möglichst preiswert herstellen zu können, wird ein Hohlkörper verwendet, der die Form eines Quaders besitzt und an einer Seite offen ist. Über diese Öffnung wird in den Hohlraum ein Körper so eingepresst, dass der verbleibende Hohlraum eine U-ähnliche Form erhält. Der Kühlblock wird nun so auf dem Kühlkörper befestigt, dass seine beiden Öffnungen, die den beiden Schenkeln des U-förmigen Hohlraums entsprechen, über zwei Bohrungen in dem Kühlkörper zu liegen kommen.

In einem anderen Ausführungsbeispiel wird ein Körper zentriert in den Hohlraum des Kühlblocks eingebracht. Durch eine entsprechende Ausformung des Hohlraums, der mit seinen Innenwänden den Körper nur an wenigen Stellen abstützt und so in seiner zentrierten Lage hält, kann erreicht werden, dass alle fünf freien Flächen des quaderförmigen Kühlblocks als Kühlflächen dienen und die Kühlflüssigkeit rings um den zentrierten Körper strömen kann.

Weitere Einzelheiten und Vorteile der Erfindung ergeben sich aus den Unteransprüchen im Zusammenhang mit der Beschreibung eines Ausführungsbeispiels, das anhand der Zeichnung eingehend erläutert wird.

Es zeigt:
- Fig. 1: eine Gesamtansicht eines erfindungsgemäßen Aufbaus für eine Stromversorgung in einer ersten Ausführungsform,
- Fig. 2: den Kühlkörper einer weiteren Ausführungsform,
- Fig. 3: einen Kühlblock in einer ersten Version,
- Fig. 4: einen Kühlblock in einer zweiten Version und
- Fig. 5: einen Schnitt durch den Kühlblock aus Fig. 4

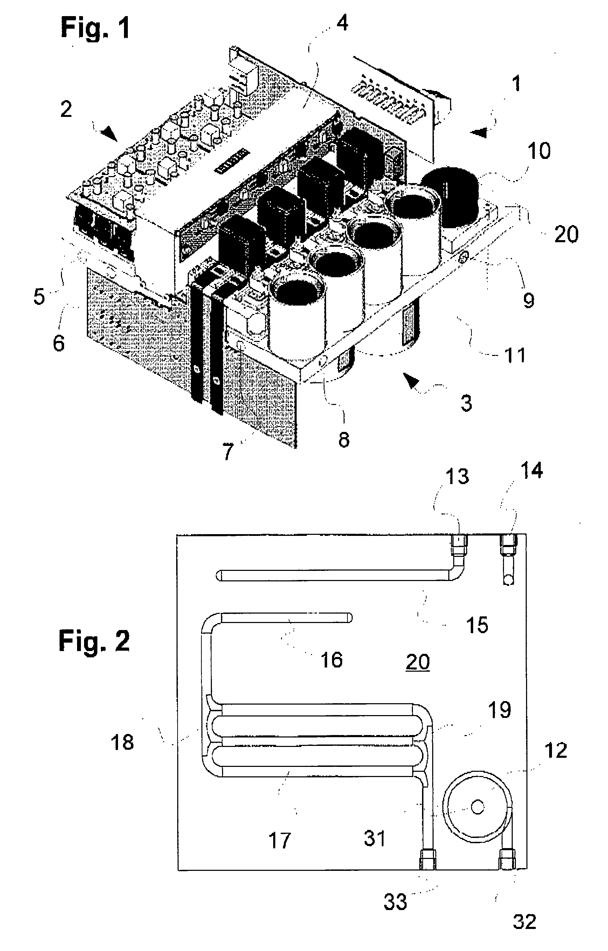

Der in Fig. 1 dargestellte Aufbau für eine Stromversorgung 1 basiert auf einem Kühlkörper 20, der gleichzeitig als Grundplatte für den Aufbau dient. Auf diesem Kühlkörper 20 sind die elektrischen Komponenten montiert. Diese sind sowohl funktionell als auch räumlich zu einem Eingangskreis 2, einem Ausgangskreis 3 und der Steuerelektronik 4 zusammengefasst. Auf diese Weise entsteht ein sehr kompakter Aufbau, der auch kurze Wege zwischen den einzelnen elektrischen Komponenten gewährleistet. Um eine Beeinflussung der Steuerelektronik 4 durch Felder der Leistungselektronik in dem Eingangskreis 2 und dem Ausgangskreis 3 zu verhindern, ist die Steuerelektronik 4 in einer Abschirmbox untergebracht.

Die Wärmeenergie wird von den Komponenten der Leistungselektronik im Eingangskreis 2 und im Ausgangskreis 3 durch ein Kühlmittel abgeführt. Die Kühlmittelkanäle sind direkt in den Kühlkörper 20 integriert. Um das Kühlmittel durch die Kühlmittelkanäle zu bewegen ist eine Pumpe 10 vorgesehen, die aus dem Kühlmittelvorratsbehälter 11 versorgt wird. Auch das hier nicht sichtbare Spiralgehäuse der Pumpe 10 ist direkt in den Kühlkörper 20 integriert.

In dem in Fig. 1 gezeigten Ausführungsbeispiel sind die Kühlmittelkanäle über Tieflochbohrungen in den Kühlkörper 20 eingebracht worden. Die sichtbaren Bohrlöcher sind mit den Bezugszeichen 5-9 versehen.

Das in Fig. 2 gezeigte Ausführungsbeispiel des Kühlkörpers 20, mit dem nicht nur die Stromversorgung, wie in dem Ausführungsbeispiel nach Fig. 1, sondern zusätzlich ein an die Stromversorgung angeschlossener Verbraucher gekühlt werden kann, wurde dagegen anders hergestellt. Hier wurden die Kühlkanäle in die Oberfläche eingefräst Es lässt sich dabei gut erkennen, dass hier die Verbindungen zwischen geraden Teilstücken 15-19 der Kühlmittelkanäle nicht eckig wie bei dem gebohrten Ausführungsbeispiel, sondern rund ausgebildet sind. Dadurch lässt sich der Strömungswiderstand erheblich verringern. Weiterhin bleibt der Kühlkörper, bei gleicher Dicke, stabiler, da die Kühlmittelkanäle nicht bis zu den Schmalseiten fortgeführt werden müssen.

Bei dem Ausführungsbeispiel nach Fig. 2 sind an den Schmalseiten des Kühlkörpers 20 einerseits lediglich die beiden Öffnungen 13 und 14 und andererseits die beiden Öffnungen 32 und 33 vorhanden. Ansonsten sind die Schmalseiten ohne die Bohrungen 5-8, wie in Fig. 1, die nach dem Bohren wieder verschlossen werden müssen. Die entsprechenden geraden Teilstücke 15-19 der Kühlmittelkanäle und die sie verbindenden Rundungen werden direkt in die Oberfläche eingefräst. Um ein geschlossenes Kühlsystem zu erhalten werden die offenen Kühlmittelkanäle mit einer Kühlplatte abgedeckt und geschlossen, Es ist unerheblich, wie diese in der Zeichnung nicht gezeigte Kühlplatte auf dem Kühlkörper 20 befestigt wird. Sie kann beispielsweise flächig aufgeklebt werden, so dass der Kleber gleichzeitig als Dichtungsmasse fungiert. Eine andere Möglichkeit ist es, eine Dichtungsfolie aufzulegen, aus der das Muster der Kühlmittelkanäle ausgestanzt ist. Auf diese Dichtungsfolie kann die Kühlplatte dann aufgelegt und mit dem Kühlkörper 20 verschraubt werden.

Genauso wie die Kühlmittelkanäle, ist in den Kühlkörper 20 das Spiralgehäuse 12 der Kreiselpumpe 10 integriert, welches ebenfalls In die Oberfläche eingefräst Ist. Im Zentrum des Spiralgehäuses 12 befindet sich eine Versorgungsbohrung 31, die die Kreiselpumpe 10 mit dem Kühlmittelvorratsbehälter 11 auf der anderen Seite des Kühlkörpers 20 verbindet, so dass die Pumpe 10 direkt aus diesem Behälter 11 ansaugen kann. Die Kreiselpumpe 10 drückt das angesaugte Kühlmittel in den tangential abzweigenden Kühlmittelkanal 19.

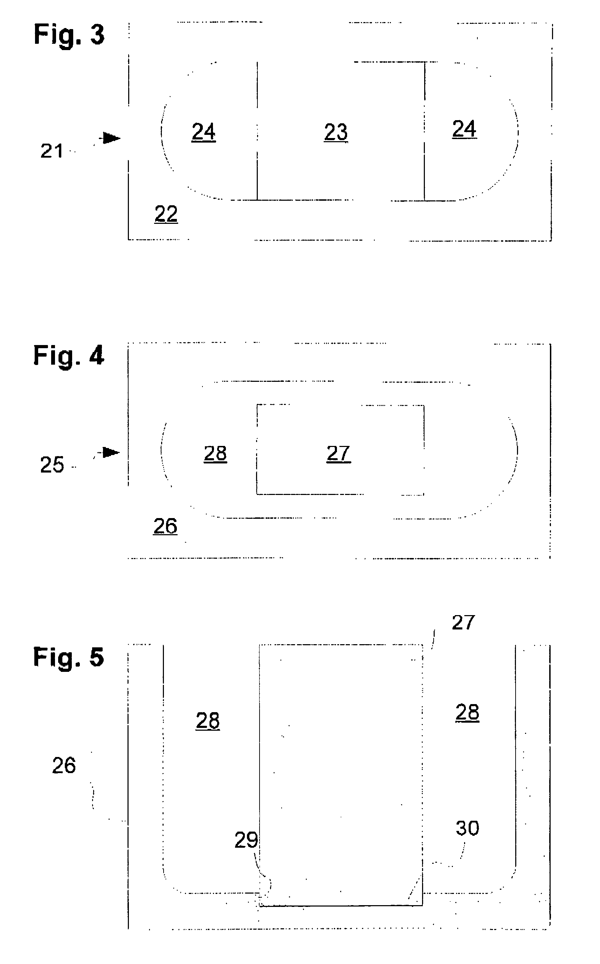

Die zu kühlenden elektrischen Komponenten der Leistungselektronik im Eingangs- 2 und Ausgangskreis 3 sind auf Kühlblöcke 21, 25 (siehe Fig. 3-5) montiert. Um die Kühlblöcke mit Kühlmittel zu versorgen sind in der nicht gezeigten Kühlplatte Bohrungen vorhanden, so dass das Kühlmittel aus den Kühlkanälen über diese Bohrungen in die Kühlblöcke und von dort über weitere Bohrungen wieder in die Kühlmittelkanäle des Kühlkörpers 20 zurückströmen kann. Zwei Versionen 21 und 25 solcher Kühlblöcke sind in den Figuren 3-5 gezeigt.

Der quaderförmige Hohlkörper 22 ist an einer Seite offen. In dem Höhlraum 24 wird ein Einpresskörper 23 durch die Seitenwände des Hohlkörpers 22 festgehalten. Dieser Einpresskörper 23 weist eine Höhe auf, die geringer als die Tiefe des Hohlraumes 24 in dem Hohlkörper 22 ist. Auf diese Weise bleibt zwischen den Hohlräumen auf beiden Seiten des Einpresskörpers 23 eine Verbindung bestehen, so dass ein U-förmiger Kühlmittelkanal in dem Kühlblock 21 entsteht. Der Hohlkörper 22 kann am Boden der Öffnung rund ausgeformt sein. Weist auch der Einpresskörper 23 an der dem Boden des Hohlraums 24 gegenüber liegenden Stelle eine Rundung auf, so entsteht ein Kühlmittelkanal ohne Ecken mit geringem Strömungswiderstand. Mit den in Fig. 3 gezeigten offenen Seiten der Schenkel des U-förmigen Kühlmittelkanals wird der Kühlblock auf den Zu- und Abflussbohrungen in der Kühlplatte montiert.

In den Figuren 4 und 5 ist ein weiteres Ausführungsbeispiel eines Kühlblocks 25 gezeigt, in dem ein eher ringförmiger Kühlmittelkanal ausgebildet ist. Hier weist der quaderförmige Hohlkörper 26 in dem Boden seines Hohlraums 28 eine Zentriermulde 29 auf, in der der Zentrierflansch 30 des Einpresskörpers 27 fest fixiert ist. Anders als in dem hier gezeigten Beispiel kann der Zentrierflansch 30 aber auch schmäler als der Finpresskörper 27 und höher als die Tiefe der Zentriermulde 29 sein, so dass zwischen dem Boden des Hohlraums 28 und dem Einpresskörper 27 noch Raum für den Durchfluss von Kuhlmittel verbleibt. Ebenso könnten zwei Zentrierflansche und zwei Zentriermulden vorgesehen sein, so dass zwischen den beiden Zentrierflanschen Kühlmittel fließen kann.

Das Kühlmittel wird von der Kreiselpumpe 10, 12 über die Versorgungsbohrung 31 aus dem Vorratsbehälter 11 angesaugt. Die Kreiselpumpe 10, 12 drückt das Kühlmittel in den Kühlmittelzulauf 32, beispielsweise für eine Laserlichtquelle. Auf diese Weise nicht nur die Stromversorgung selbst, sondern auch noch der von der Stromversorgung versorgte Verbraucher gekühlt.

Von der Laserlichtquelle strömt das Kühlmittel über den Rücklauf 32 wieder in den Kühlmittelkanal 19 des Kühlkörpers 20. Von dort wird es in das gerade Teilstück 17 und die beiden dazu parallel verlaufenden Kühlmittelkanäle verteilt. Über diesen drei parallelen Kühlmittelkanälen sind Kühlblöcke 21, 25 angeordnet, auf denen die Leistungselektronik des Ausgangskreises 3 montiert ist. Nach dem Durchfluss dieser Kühlblöcke wird das Kühlmittel wieder gesammelt und über die Kühlmittelkanäle 18 und 16 dem Eingangs kreis 2 zugeführt.

Über den geraden Teilstücken 16 und 15 sind die Kühlblöcke für den Eingangskreis 2 angeordnet. Aus dem Kühlmittelkanal 15 fließt das Kühlmittel über den Kühlmittelabfluss 13 aus dem Kühlkörper 20 ab und wird einem hier nicht gezeigten Wärmetauscher zugeführt, in dem dem Kühlmittel die Wärmeenergie entzogen wird. Die entzogene Wärme kann genutzt oder auch nur an die Umgebungsluft abgeführt werden.

Das abgekühlte Kühlmittel wird dem Kühlkörper 20 durch den Zulauf 14 wieder zugeführt und von dort in den Vorratsbehälter 11 geleitet, wo es der Pumpe 10 wiederum zur Vertügung steht.

### Bezugszeichenliste:

- 1: Stromversorgung
- 2: Eingangskreis
- 3: Ausgangskreis
- 4: Steuerelektronik
- 5-9: Tieflochbohrungen
- 10: Pumpe
- 11: Behälter für Kühlmittel
- 12: Pumpengehäuse
- 13: Ablauf zum Wärmetauscher
- 14: Zulauf in den Behälter für Kühlmittel
- 15-19: gefräste Kühlkanäle
- 20: Kühlkörper
- 21: Kühlblock Version 1
- 22: Hohlkörper
- 23: Einpresskörper
- 24: Kühlmittelkanal
- 25: Kühlblock Version 2
- 26: Hohlkörper Version 2
- 27: Einpresskörper Version 2
- 28: Kühlmittelraum
- 29: Zentriermulde
- 30: Zentrierflansch
- 31: Versorgungsbohrung
- 32: Kühlmittelzulauf für Laserquelle
- 33: Kühlmittelrücklauf von Laserquelle

## Patentansprüche

1. Aufbau für eine Stromversorgung mit einer Kühleinrichtung, wobei die Kühleinrichtung einen Kreislauf für ein Kühlmittel mit einer Kühlmittelpumpe mit Pumpengehäuse und Pumpenrotor aufweist, **dadurch gekennzeichnet, dass** ein Kühlkörper vorgesehen ist, in den Kühlmittelkanäle und das Pumpengehäuse integriert sind.

2. Aufbau für eine Stromversorgung nach Anspruch 1, **dadurch gekennzeichnet, dass** der Kühlkörper als Grundplatte für die elektrischen Komponenten der Stromversorgung dient.

3. Aufbau für eine Stromversorgung nach Anspruch 2, **dadurch gekennzeichnet, dass** an dem Kühlkörper ein Behälter für das Kühlmittel so befestigt ist, dass das Kühlmittel von der Kühlmittelpumpe durch eine Bohrung in dem Kühlkörper direkt angesaugt werden kann.

4. Aufbau für eine Stromversorgung nach Anspruch 3, **dadurch gekennzeichnet, dass** der Abstand des Pumpengehäuse zu einer Seitenkante des Kühlkörpers ein Vielfaches des Abstands zu der gegenüberliegenden Seitenkante beträgt.

5. Aufbau für eine Stromversorgung nach Anspruch 2, **dadurch gekennzeichnet, dass** die Kühlmittelkanäle in dem Kühlkörper durch Tieflochbohrungen erzeugt werden.

6. Aufbau für eine Stromversorgung nach Anspruch 2, **dadurch gekennzeichnet, dass** die Kühlmittelkanäle in dem Kühlkörper durch Fräsen erzeugt werden.

7. Aufbau für eine Stromversorgung nach Anspruch 6, **dadurch gekennzeichnet, dass** die Kühlmittelkanäle in dem Kühlkörper durch eine Kühlplatte abgedeckt werden.

8. Aufbau für eine Stromversorgung nach Anspruch 2, **dadurch gekennzeichnet, dass** die elektrischen Komponenten der Stromversorgung räumlich in einen Eingangskreis, einen Ausgangskreis und eine Steuerelektronik unterteilt sind.

9. Aufbau für eine Stromversorgung nach Anspruch 8, **dadurch gekennzeichnet, dass** die Steuerungselektronik in einer Abschirmbox zwischen dem Eingangskreis und dem Ausgangskreis angeordnet ist.

10. Aufbau für eine Stromversorgung nach Anspruch 8, **dadurch gekennzeichnet, dass** Kühlblöcke für den Eingangskreis und den Ausgangskreis vorgesehen sind, die über Bohrungen in dem Kühlkörper oder der Kühlplatte mit Kühlmittel versorgt werden.

11. Aufbau für eine Stromversorgung nach Anspruch 10, **dadurch gekennzeichnet, dass** die Kühlblöcke einen Hohlraum aufweisen, in den ein Körper so eingebracht ist, dass ein U-förmiger Kühlkanal entsteht.

12. Aufbau für eine Stromversorgung nach Anspruch 10, **dadurch gekennzeichnet, dass** die Kühlblöcke einen Hohlraum aufweisen, in den ein Körper so eingebracht ist, dass bei einem quaderförmigen Kühlblock an fünf Seiten des Körpers Kühlflächen entstehen.

## Geänderte Patentansprüche

### Geänderte Patentansprüche gemäss Regel 137(2) EPÜ.

**1.** Aufbau für eine Stromversorgung mit einer Kühleinrichtung, wobei die Kühleinrichtung einen Kreislauf für ein Kühlmittel mit einer Kühlmittelpumpe mit Pumpengehäuse und Pumpenrotor aufweist, **dadurch gekennzeichnet, dass** ein Kühlkörper vorgesehen ist, in den Kühlmittelkanäle integriert sind und in den das Pumpengehäuse direkt als Vertiefung eingebracht ist.
